# EUROPÄISCHE PATENTANMELDUNG

(11) **EP 3 388 851 A1**
(43) Veröffentlichungstag der Anmeldung: **17.10.2018**
(21) Anmeldenummer: 18165698.4
(22) Anmeldetag: 04.04.2018
(51) Int. Cl.: G01R 31/327, G01R 31/28

(54) **SCHALTANORDNUNG ZUR ÜBERPRÜFUNG EINES SCHALTELEMENTS**

(30) Priorität: 10.04.2017 DE 102017206102
(71) Anmelder: BSH Hausgeräte GmbH, 81739 München (DE)
(72) Erfinder: Hönle, Christian, 93093 Donaustauf (DE); Stark, Alexander-Manuel, 93049 Regensburg (DE); Zaruba, Károly, 93089 Aufhausen (DE)

(57) **Zusammenfassung**

Es wird eine Schaltanordnung (200) für ein elektrisches Gerät beschrieben, wobei das elektrische Gerät eine Last (103) aufweist, die über eine Reihenschaltung aus einem Sicherheits-Schaltelement (101) und einem Arbeits-Schaltelement (102) zur Energieversorgung mit einer Arbeitsspannung gekoppelt werden kann. Die Schaltanordnung (200) umfasst, ein Hilfs-Schaltelement (122), das eingerichtet ist, eine Seite des Arbeits-Schaltelements (102) mit einer Hilfsspannung (121) zu koppeln. Außerdem umfasst die Schaltanordnung (200) einen ersten Messpfad (123), der eingerichtet ist, eine erste Seite des Arbeits-Schaltelements (102) mit einem ersten Messeingang (211) einer Recheneinheit zu koppeln, sowie einen zweiten Messpfad (124), der eingerichtet ist, eine zweite Seite des Arbeits-Schaltelements (102) mit einem zweiten Messeingang (212) der Recheneinheit zu koppeln. Des Weiteren umfasst die Schaltanordnung (200) die Recheneinheit, die eingerichtet ist, das Hilfs-Schaltelement (122) zu veranlassen, eine Seite des Arbeits-Schaltelements (102) mit der Hilfsspannung (121) zu koppeln. Die Recheneinheit ist ferner eingerichtet, erste Messdaten an dem ersten Messeingang (211) und zweite Messdaten an dem zweiten Messeingang (212) zu erfassen. Außerdem ist die Recheneinheit eingerichtet, auf Basis der ersten Messdaten und auf Basis der zweiten Messdaten einen Zustand des Arbeits-Schaltelements (102) zu bestimmen.

## Beschreibung

Die Erfindung betrifft eine Schaltanordnung zur Überprüfung eines Schaltelements, insbesondere eines Relais, eines elektrischen Geräts.

Elektrische Geräte können aus Sicherheitsgründen mehrere in Reihe geschaltete Schaltelemente, insbesondere Relais, aufweisen. Insbesondere kann eine Last (z.B. ein Heizelement) eines elektrischen Geräts über ein Arbeits-Schaltelement von einer Arbeitsspannung entkoppelt werden, um den Betrieb der Last zu beenden. Des Weiteren kann ein Sicherheits-Schaltelement dazu verwendet werden, die Arbeitsspannung (insbesondere die Netzspannung eines Versorgungsnetzes) an dem Arbeits-Schaltelement bereitzustellen bzw. von dem Arbeits-Schaltelement zu trennen.

Das vorliegende Dokument befasst sich mit der technischen Aufgabe, eine Schaltanordnung bereitzustellen, mit der in zuverlässiger und sicherer Weise ein Schaltelement eines elektrischen Geräts überprüft werden kann.

Die Aufgabe wird durch den Gegenstand des unabhängigen Patentanspruchs gelöst. Vorteilhafte Ausführungsformen sind insbesondere in den abhängigen Patentansprüchen definiert, in nachfolgender Beschreibung beschrieben oder in der beigefügten Zeichnung dargestellt.

Gemäß einem Aspekt der Erfindung wird eine Schaltanordnung für ein elektrisches Gerät, insbesondere für ein Hausgerät bzw. ein Haushaltsgerät, z.B. ein Kochfeld, einen Ofen, eine Waschmaschine, eine Spülmaschine, einen Wäschetrockner, etc, beschrieben. Das elektrische Gerät weist eine elektrische Last (z.B. ein Heizelement) auf, die über eine Reihenschaltung aus einem Sicherheits-Schaltelement und einem Arbeits-Schaltelement zur Energieversorgung mit einer Arbeitsspannung gekoppelt werden kann. Die Arbeitsspannung kann z.B. einer Netzspannung eines Versorgungsnetzes entsprechen. Die Arbeitsspannung kann weiter eine Wechselspannung sein, beispielsweise eine 230V Wechselspannung mit einer Netzfrequenz von 50Hz oder eine 130V Wechselspannung mit einer Netzfrequenz von 60Hz.

Die Arbeitsspannung kann z.B. über einen ersten Leiter (z.B. einen L-Leiter) und über einen zweiten Leiter (z.B. einen N-Leiter) eines Netzsteckers des elektrischen Geräts bereitgestellt werden. Das Sicherheits-Schaltelement, das Arbeits-Schaltelement und die Last können dann eine Reihenschaltung bilden, die zwischen dem ersten Leiter und dem zweiten Leiter angeordnet ist. Mit anderen Worten, das elektrische Gerät kann einen Lastpfad aufweisen, der eine Last über ein Arbeits-Schaltelement und über ein Sicherheits-Schaltelement mit einer Arbeitsspannung koppelt. Das Arbeits-Schaltelement kann dabei ausgebildet sein, die Energieversorgung der Last bereitzustellen oder zu unterbinden. Des Weiteren kann das Sicherheits-Schaltelement ausgebildet sein, die Arbeitsspannung an dem Arbeits-Schaltelement bereitzustellen oder von dem Arbeits-Schaltelement zu entkoppeln. Das Sicherheits-Schaltelement und/oder das Arbeits-Schaltelement können dabei jeweils zumindest ein Relais umfassen bzw. jeweils ein Relais sein.

Die Schaltanordnung umfasst ein Hilfs-Schaltelement, das eingerichtet ist, eine Seite des Arbeits-Schaltelements mit einer Hilfsspannung zu koppeln. Dabei kann die Hilfsspannung ein gegenüber einem Maximalwert der Arbeitsspannung reduziertes Spannungsniveau aufweisen. Bevorzugt ist die Hilfsspannung eine Gleichspannung. Die Hilfsspannung kann z.B. mittels eines Wandlers (insbesondere eines AC/DC-Wandlers) aus der Arbeitsspannung generiert werden. Besonders bevorzugt liegt die Hilfsspannung bei 60V oder weniger, z.B. bei 12V. Die Hilfsspannung kann z.B. dazu verwendet werden, die Elektronik innerhalb des elektrischen Geräts zu betreiben.

Außerdem umfasst die Schaltanordnung einen ersten Messpfad, der eingerichtet ist, eine erste Seite des Arbeits-Schaltelements mit einem ersten Messeingang einer Recheneinheit zu koppeln. Die Recheneinheit kann einen Mikrocontroller umfassen oder ein Mikrocontroller sein. Der erste Messeingang kann einen Analog-Digital Wandler umfassen, um eine am ersten Messeingang anliegende erste Spannung in erste Messdaten umzuwandeln. Der erste Messpfad ist dabei derart ausgelegt, dass die erste Spannung am ersten Messeingang von dem Potential (relativ zu einem Referenz-Potential wie z.B. Ground) an der ersten Seite des Arbeits-Schaltelements abhängt.

Die Schaltanordnung umfasst ferner einen zweiten Messpfad, der eingerichtet ist, eine zweite Seite des Arbeits-Schaltelements mit einem zweiten Messeingang der Recheneinheit zu koppeln. Der zweite Messeingang kann einen Analog-Digital Wandler umfassen, um eine am zweiten Messeingang anliegende zweite Spannung in zweite Messdaten umzuwandeln. Der zweite Messpfad ist dabei derart ausgelegt, dass die zweite Spannung am zweiten Messeingang von dem Potential (relativ zu einem Referenz-Potential wie z.B. Ground) an der zweiten Seite des Arbeits-Schaltelements abhängt.

Des Weiteren umfasst die Schaltanordnung die Recheneinheit. Die Recheneinheit ist dabei eingerichtet, das Hilfs-Schaltelement zu veranlassen, eine Seite des Arbeits-Schaltelements (z.B. die erste Seite oder die zweite Seite) mit der Hilfsspannung zu koppeln. Insbesondere kann eine Seite des Arbeits-Schaltelements für einen zeitlich begrenzten Messzeitraum mit der Hilfsspannung gekoppelt werden. Das Potential an der mit der Hilfsspannung gekoppelten Seite des Arbeits-Schaltelements entspricht dann substantiell der Hilfsspannung.

Die Recheneinheit ist ferner eingerichtet, erste Messdaten an dem ersten Messeingang und zweite Messdaten an dem zweiten Messeingang zu erfassen. Dabei zeigen die ersten Messdaten das Potential an der ersten Seite des Arbeits-Schaltelements und die zweiten Messdaten das Potential an der zweiten Seite des Arbeits-Schaltelements an. Außerdem ist die Recheneinheit eingerichtet, auf Basis der ersten Messdaten und auf Basis der zweiten Messdaten einen Zustand des Arbeits-Schaltelements zu bestimmen.

Insbesondere kann auf Basis der ersten und zweiten Messdaten ein Spannungsabfall über dem Arbeits-Schaltelement ermittelt werden. Außerdem kann bestimmt werden, ob der Spannungsabfall größer oder kleiner als ein bestimmter Spannungsschwellenwert ist. Basierend darauf kann bestimmt werden, ob das Arbeits-Schaltelement in einem geöffneten Zustand oder in einem geschlossenen Zustand ist. Insbesondere kann ermittelt werden, ob das Arbeits-Schaltelement im geöffneten Zustand ist, obwohl es geschlossen sein sollte, oder ob das Arbeits-Schaltelement im geschlossenen Zustand ist, obwohl es geöffnet sein sollte. Es kann somit bestimmt werden, ob das Arbeits-Schaltelement eingeklemmt bzw. verklebt ist.

Die Bereitstellung einer Hilfsspannung ermöglicht die zuverlässige und sichere Bestimmung des Zustands eines Arbeits-Schaltelements. Insbesondere kann noch vor Schließen des Sicherheits-Schaltelements und/oder noch vor Bereitstellung der Arbeitsspannung an dem Arbeits-Schaltelement der Zustand des Arbeits-Schaltelements bestimmt werden. Des Weiteren ist die Schaltanordnung aufgrund der Ermittlung einer Differenzspannung über dem Arbeits-Schaltelement robust in Bezug auf ein Vertauschen der Leiter eines Netzsteckers des elektrischen Geräts.

Die Recheneinheit kann eingerichtet sein, zu bestimmen, dass das Sicherheits-Schaltelement geöffnet ist und/oder dass das Arbeits-Schaltelement nicht mit der Arbeitsspannung gekoppelt ist. Die Recheneinheit kann dann in Reaktion darauf das Hilfs-Schaltelement veranlassen, eine Seite des Arbeits-Schaltelements mit der Hilfsspannung zu koppeln. Die Recheneinheit kann somit veranlassen, dass die Ermittlung des Zustands des Arbeits-Schaltelements auf Basis der Hilfsspannung nur dann erfolgt, wenn keine Arbeitsspannung an dem Arbeits-Schaltelement anliegt.

Des Weiteren kann die Recheneinheit eingerichtet sein, zu bestimmen, dass das Arbeits-Schaltelement mit der Arbeitsspannung gekoppelt ist. Das Hilfs-Schaltelement kann veranlasst werden und/oder kann ausgebildet sein, das Arbeits-Schaltelement von der Hilfsspannung zu entkoppeln, solange das Arbeits-Schaltelement mit der Arbeitsspannung gekoppelt ist. So kann gewährleistet werden, dass die Energieversorgung der Last nicht durch die Hilfsspannung beeinträchtigt wird. Des Weiteren kann so gewährleistet werden, dass eine Spannungsquelle zur Bereitstellung der Hilfsspannung nicht durch die Arbeitsspannung beeinträchtigt wird.

Der erste Messpfad kann einen ersten Spannungsteiler (z.B. mit einem ersten Highside-Widerstand und einem ersten Lowside-Widerstand) mit einem ersten Mittelpunkt (zwischen dem ersten Highside-Widerstand und dem ersten Lowside-Widerstand) aufweisen. Der erste Spannungsteiler kann dabei die erste Seite des Arbeits-Schaltelements mit einem Referenz-Potential (z.B. mit Masse oder Ground) koppeln. Des Weiteren kann der erste Mittelpunkt des ersten Spannungsteilers mit dem ersten Messeingang gekoppelt sein. In entsprechender Weise kann der zweite Messpfad einen zweiten Spannungsteiler (z.B. mit einem zweiten Highside-Widerstand und einem zweiten Lowside-Widerstand) mit einem zweiten Mittelpunkt (zwischen dem zweiten Highside-Widerstand und dem zweiten Lowside-Widerstand) aufweisen. Der zweite Spannungsteiler kann dabei die zweite Seite des Arbeits-Schaltelements mit dem Referenz-Potential koppeln. Des Weiteren kann der zweite Mittelpunkt des zweiten Spannungsteilers mit dem zweiten Messeingang gekoppelt sein. So können in präziser Weise die Potentiale an der ersten und zweiten Seite des Arbeits-Schaltelements an die Messeingänge der Recheneinheit überführt werden.

Der erste Mittelpunkt des ersten Spannungsteilers kann über einen ersten Tiefpassfilter, insbesondere über ein erstes RC-Glied, mit dem ersten Messeingang gekoppelt sein. In entsprechender Weise kann der zweite Mittelpunkt über einen zweiten Tiefpassfilter, insbesondere über ein zweites RC-Glied, mit dem zweiten Messeingang gekoppelt sein. So können die Potentiale an der ersten und zweiten Seite des Arbeits-Schaltelements in präziser Weise durch die Recheneinheit erfasst werden.

Wie bereits oben dargelegt können der erste Spannungsteiler einen ersten Highside-Widerstand und der zweite Spannungsteiler einen zweiten Highside-Widerstand aufweisen, wobei der erste Highside-Widerstand mit der ersten Seite des Arbeits-Schaltelements und der zweite Highside-Widerstand mit der zweiten Seite des Arbeits-Schaltelements gekoppelt sind. Der erste Highside-Widerstand und der zweite Highside-Widerstand können dabei für einen Betrieb mit der Arbeitsspannung ausgelegt sein. Des Weiteren können der erste Highside-Widerstand und der zweite Highside-Widerstand bei Betrieb mit der Arbeitsspannung einen Strom durch den ersten bzw. zweiten Spannungsteiler derart begrenzen, dass eine Spannung an dem ersten bzw. zweiten Mittelpunkt eine Logikspannung (z.B. 5V) der Recheneinheit nicht überschreitet.

Die Spannungsteiler können somit auch für einen Betrieb mit der Arbeitsspannung ausgelegt sein. Des Weiteren können die Spannungsteiler derart ausgelegt sein, dass auch wenn an dem Arbeits-Schaltelement die Arbeitsspannung anliegt, die Potentiale an den Mittelpunkten der Spannungsteiler durch die Messeingänge der Recheneinheit erfasst werden können (wobei der erfassbare Bereich der Messeingänge typischerweise auf die Logikspannung der Recheneinheit begrenzt ist). Somit kann mittels der Schaltanordnung in effizienter Weise eine Überwachung eines Arbeits-Schaltelements vor Betrieb einer Last und während des Betriebs einer Last erfolgen.

Der erste Messpfad kann eine erste Diode umfassen, über die der erste Mittelpunkt des ersten Spannungsteilers mit der Logikspannung der Recheneinheit gekoppelt ist. In entsprechender Weise kann der zweite Messpfad eine zweite Diode umfassen, über die der zweite Mittelpunkt des zweiten Spannungsteilers mit der Logikspannung der Recheneinheit gekoppelt ist. Es kann somit eine Begrenzung des Potentials an den Messeingängen erfolgen, um eine Schädigung der Recheneinheit bei Betrieb mit der Arbeitsspannung zu vermeiden.

Das Hilfs-Schaltelement kann eine Reihenschaltung aus einem Hilfs-Transistor, insbesondere einem Metalloxid-Halbleiter, MOS, Transistor, und einer Hilfs-Diode umfassen, wobei die Hilfs-Diode in Richtung zu der Hilfsspannung sperrend ist. So kann in zuverlässiger Weise eine Kopplung oder eine Entkopplung des Arbeits-Schaltelements und der Hilfsspannung bewirkt werden.

Gemäß einem weiteren Aspekt wird ein elektrisches Geräts, insbesondere ein Hausgerät bzw. ein Haushaltsgerät, beschrieben, das die in diesem Dokument beschriebene Schaltanordnung umfasst.

Es ist zu beachten, dass jegliche Aspekte der in diesem Dokument beschriebenen Schaltanordnung in vielfältiger Weise miteinander kombiniert werden können. Insbesondere können die Merkmale der Patentansprüche in vielfältiger Weise miteinander kombiniert werden.

Im Weiteren wird die Erfindung anhand von in der beigefügten Zeichnung dargestellten Ausführungsbeispielen näher beschrieben. Dabei zeigen
- Figur 1: einen beispielhaften Lastpfad eines elektrischen Geräts; und
- Figur 2: eine beispielhafte Schaltanordnung zur Überprüfung eines Schaltelements.

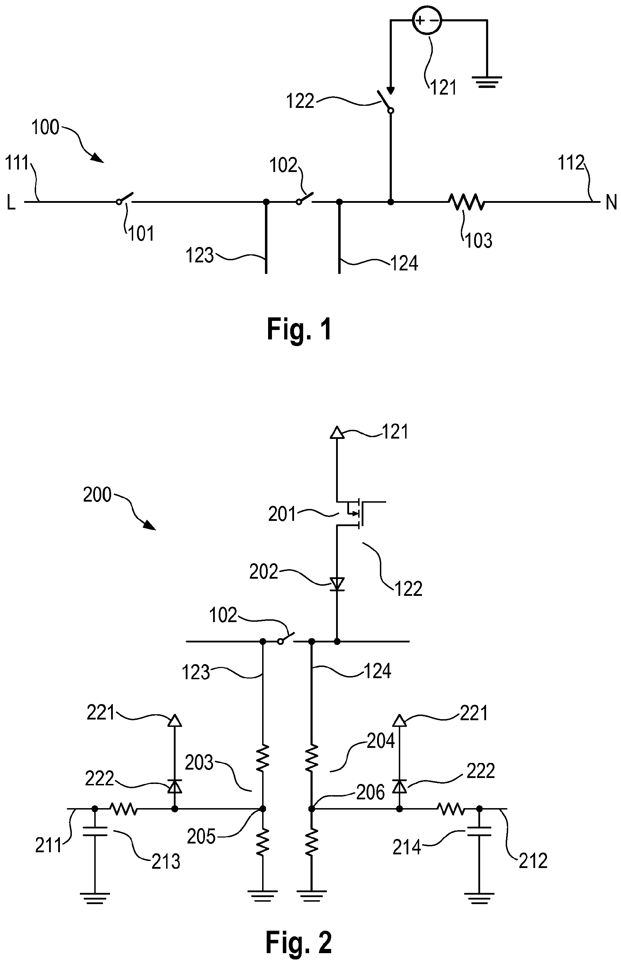

Wie eingangs dargelegt, befasst sich das vorliegende Dokument mit der zuverlässigen und sicheren Überprüfung eines Schaltelements auf einem Lastpfad eines elektrischen Geräts. In diesem Zusammenhang zeigt Fig. 1 einen beispielhaften Lastpfad 100 für die Energieversorgung einer Last 103 (z.B. eines elektrischen Heizelements) eines elektrischen Geräts (z.B. eines Kochfelds oder eines Ofens). Der Lastpfad 100 verbindet dabei die Last 103 mit einer Arbeitsspannung (z.B. mit einer durch ein Versorgungsnetz bereitgestellten Netzspannung). Insbesondere kann die Last 103 mit einem ersten Leiter 111 (z.B. dem Phasenleiter L) und einem zweiten Leiter 112 (z.B. dem Neutralleiter N) verbunden werden.

Der in Fig. 1 dargestellte Lastpfad 100 umfasst ein Arbeits-Schaltelement 102 (z.B. ein Relais) und ein Sicherheits-Schaltelement 101 (z.B. ein Relais), die in Reihe mit der Last 103 zwischen den Leitern 111, 112 angeordnet sind. Mit dem Sicherheits-Schaltelement 101 kann die Arbeitsspannung bereitgestellt werden und mit dem Arbeits-Schaltelement 102 kann die Last aktiviert werden.

Es kann vorkommen, dass das Arbeits-Schaltelement 102 eine Fehlfunktion aufweist, insbesondere leitend ist, obwohl die Last 103 nicht mit elektrischer Energie versorgt werden soll. Beispielsweise kann bei Verwendung eines Arbeitsrelais das Relais verklebt sein, so dass die Last 103 fehlerhaft mit elektrischer Energie versorgt wird. Um eine derartige Situation zu vermeiden, kann eine Überprüfung des Arbeits-Schaltelements 102 erfolgen. Zu diesem Zweck kann an beiden Seiten des Arbeits-Schaltelements 102 jeweils ein Messpfad 123, 124 angeordnet werden, um einen Spannungsabfall über dem Arbeits-Schaltelement 102 zu detektieren.

Beispielsweise kann zur Überprüfung des Zustands des Arbeits-Schaltelements 102 das Sicherheits-Schaltelement 101 geschlossen werden, so dass das Arbeits-Schaltelement 102 sowohl mit dem ersten Leiter 111 (über das geschlossenen Sicherheits-Schaltelement 101) als auch mit dem zweiten Leiter 112 (über die Last 103) gekoppelt ist. Es kann dann über die Messpfade 123, 124 die Spannung über dem Arbeits-Schaltelement 102 ermittelt werden. Des Weiteren kann auf Basis der ermittelten Spannung über dem Arbeits-Schaltelement 102 bestimmt werden, ob das Arbeits-Schaltelement 102 geschlossen oder geöffnet ist.

Durch das Schließen des Sicherheits-Schaltelements 101 wird die Arbeitsspannung an dem Arbeits-Schaltelement 102 bereitgestellt. Dies würde bei einem fehlerhaft geschlossenen Arbeits-Schaltelement 102 zu einer Aktivierung der Last 103 führen. Um dies zu vermeiden, kann über ein Hilfs-Schaltelement 122 (z.B. über einen Transistor) eine Hilfsspannung 121 an das Arbeits-Schaltelement 102 angelegt werden, insbesondere wenn das Sicherheits-Schaltelement 101 geöffnet ist. Die Hilfsspannung 121 kann dabei eine Niedervoltspannung (z.B. 60V DC oder weniger, insbesondere 12V) sein. Insbesondere kann eine im elektrischen Gerät verfügbare Spannung, die z.B. für den Betrieb der Elektronik des elektrischen Geräts genutzt wird, als Hilfsspannung 121 verwendet werden. Durch die Hilfsspannung 121 kann ein Spannungsabfall zwischen den Messpfaden 123, 124 erzeugt werden, um den Zustand des Arbeits-Schaltelements 102 zu überprüfen. Dabei ist die Hilfsspannung 121 typischerweise substantiell kleiner als ein Scheitelwert der Arbeitsspannung, so dass keine (substantielle) Aktivierung der Last 103 erfolgt. Es wird somit eine sichere Überprüfung des Arbeits-Schaltelements 102 ermöglicht.

Fig. 2 zeigt eine Schaltanordnung 200 zur Ermittlung des Zustands des Arbeits-Schaltelements 102 eines Lastpfads 100 eines elektrischen Geräts. Eine Seite des Arbeits-Schaltelements 102 kann für die Zustandsermittlung über ein Hilfs-Schaltelement 122 (z.B. über einen MOS-Transistor 201 in Kombination mit einer Diode 202) mit einer Hilfsspannung 121 gekoppelt werden. Dabei kann die Hilfsspannung 121 eine Gleichspannung sein. Des Weiteren kann die Hilfsspannung 121 ein gegenüber der Arbeitsspannung (substantiell) reduziertes Spannungsniveau aufweisen (z.B. ein um den Faktor 5, 10 oder mehr geringeres Spannungsniveau).

Der erste Messpfad 123 auf einer ersten Seite des Arbeits-Schaltelements 102 weist einen ersten Spannungsteiler 203 und der zweite Messpfad 124 auf einer zweiten Seite des Arbeits-Schaltelements 102 weist einen zweiten Spannungsteiler 204 auf. Die Spannungsteiler 203, 204 können die jeweilige Seite des Arbeits-Schaltelements 102 mit einem Referenz-Potential (insbesondere Masse bzw. Ground) koppeln. Die Mittelpunkte 205, 206 der Spannungsteiler 203, 204 können dann jeweils mit einem Messeingang 211, 212 einer Recheneinheit (z.B. eines Mikrocontrollers) gekoppelt sein. Die Kopplung kann dabei jeweils über einen Tiefpassfilter 213, 214 (z.B. über RC-Glieder) erfolgen, um Störungen und/oder Rauschen zu reduzieren. Die Messeingänge 211, 212 können jeweils einen Analog-Digital Wandler aufweisen, um die Potentialwerte an den Mittelpunkten 205, 206 der Spannungsteiler 203, 204 in digitale Messdaten zu überführen. Die Recheneinheit kann dann auf Basis der Messdaten bestimmen, ob das Arbeits-Schaltelement 102 geschlossen oder geöffnet ist bzw. ob das Arbeits-Schaltelement 102 defekt ist oder nicht.

Außerdem kann die Schaltanordnung 200 in jedem Messpfad 123, 124 eine Diode 222 aufweisen, mit der der Mittelpunkt 205, 206 des Spannungsteilers 205, 206 mit einer Logikspannung 221 (z.B. 5V) gekoppelt wird. Die Logikspannung 221 kann dabei der Betriebsspannung der Recheneinheit entsprechen (und ggf. mittels eines Wandlers aus der Arbeitsspannung generiert werden). Die Spannung an den Messeingängen 211, 212 kann so auf die Logikspannung 221 begrenzt werden (insbesondere wenn das Sicherheits-Schaltelement 101 geschlossen ist).

Mit der in Fig. 2 dargestellten Schaltanordnung 200 kann auch ohne Arbeitsspannung (d.h. auch bei einem geöffneten Sicherheits-Schaltelement 101) der Zustand des Arbeits-Schaltelements 102 überprüft werden. Zu diesem Zweck kann die Hilfsspannung 121 über das Hilfs-Schaltelement 122 zugeschaltet werden (z.B. gesteuert durch die Recheneinheit). Durch Messen der Spannungsdifferenz über dem Arbeits-Schaltelement 102 kann der Zustand des Arbeits-Schaltelements 102 erkannt werden. Wenn das Arbeits-Schaltelement 102 geschlossen ist, wird die Differenzspannung substantiell Null sein. Andernfalls wird ein Spannungsabfall über dem Arbeits-Schaltelement 102 gemessen. Es kann somit bereits vor Aktivierung der Last 103 der Zustand des Arbeits-Schaltelements 102 überprüft werden.

Auch im laufenden Betrieb (d.h. bei geschlossenem Sicherheits-Schaltelement 101) kann der Schaltzustand des Arbeits-Schaltelements 102 über die Differenzspannung der Messpfade 123, 124 überwacht werden. Das Hilfs-Schaltelement 122 bleibt in diesem Fall geöffnet und es kann zur Messung der Differenzspannung über dem Arbeits-Schaltelement 102 die Arbeitsspannung genutzt werden.

Durch die Messung einer Differenzspannung über dem Arbeits-Schaltelement 102 ist die Schaltungsanordnung 200 robust gegenüber der Vertauschung der Leiter 111, 112 (z.B. über einen Netzstecker).

Wie in Fig. 2 dargestellt kann als Hilfsspannung 121 die Betriebsspannung der Elektronik des elektrischen Geräts genutzt werden. Diese kann z.B. über einen Spannungswandler aus der Netzspannung generiert werden. Das Hilfs-Schaltelement 122 kann über einen PMOS-Transistor 201, in Kombination mit einer Hilfs-Diode 202, realisiert werden. Die Spannungen an den Kontakten des Arbeits-Schaltelements 102 (d.h. die Spannungen an den Messpfaden 123, 124) können über Spannungsteiler 203, 204 und Tiefpassfilter 213, 214 an die Messeingänge 211, 212 der Recheneinheit geführt werden.

Im Arbeitsbetrieb mit Netzspannung (d.h. bei geschlossenem Sicherheits-Schaltelement 101) kann die Spannung an den Messeingängen 211, 212 auf die Logik- bzw. Betriebsspannung 221 der Recheneinheit geklemmt werden. Die Highside-Widerstände der Spannungsteiler 203, 204 können für den Arbeitsbetrieb mit Netzspannung derart ausgelegt sein, dass der über die Messpfade 123, 124 fließende Strom auf einen bestimmten Maximalwert (z.B. auf die Logikspannung 221) begrenzt wird. Des Weiteren sollten die Highside-Widerstände für die Spannungen und die Verlustleistungen im Arbeitsbetrieb ausgelegt sein. Dies kann z.B. durch die Verwendung einer Reihenschaltung von Widerständen als Highside-Widerstand erreicht werden.

Mit der in Fig. 2 dargestellten Schaltanordnung 200 kann ein Arbeits-Schaltelement 102 überprüft werden, noch bevor die Arbeitsspannung über ein Sicherheits-Schaltelement 101 zugeschaltet wird. Es wird somit eine sichere und zuverlässige Überprüfung eines Arbeits-Schaltelements 102 ermöglicht. Insbesondere kann der Fehlerfall, dass beide Schaltelemente 101, 102 des Lastpfads 100 eines elektrischen Geräts verkleben und eine sicherheitskritische Situation herbeiführen, zuverlässig vermieden werde. Darüber hinaus kann das Arbeits-Schaltelement 102 auch im Betrieb eines elektrischen Geräts überwacht werden.

Die vorliegende Erfindung ist nicht auf die gezeigten Ausführungsbeispiele beschränkt. Insbesondere ist zu beachten, dass die Beschreibung und die Figuren nur das Prinzip der vorgeschlagenen Schaltanordnung veranschaulichen sollen.

## Patentansprüche

1. Schaltanordnung (200) für ein elektrisches Gerät; wobei das elektrische Gerät eine Last (103) aufweist, die über eine Reihenschaltung aus einem Sicherheits-Schaltelement (101) und einem Arbeits-Schaltelement (102) zur Energieversorgung mit einer Arbeitsspannung gekoppelt werden kann; wobei die Schaltanordnung (200) umfasst,
- ein Hilfs-Schaltelement (122), das eingerichtet ist, eine Seite des Arbeits-Schaltelements (102) mit einer Hilfsspannung (121) zu koppeln; wobei die Hilfsspannung (121) ein gegenüber einem Maximalwert der Arbeitsspannung reduziertes Spannungsniveau aufweist;
- einen ersten Messpfad (123), der eingerichtet ist, eine erste Seite des Arbeits-Schaltelements (102) mit einem ersten Messeingang (211) einer Recheneinheit zu koppeln;
- einen zweiten Messpfad (124), der eingerichtet ist, eine zweite Seite des Arbeits-Schaltelements (102) mit einem zweiten Messeingang (212) der Recheneinheit zu koppeln; und
- die Recheneinheit, die eingerichtet ist,
- das Hilfs-Schaltelement (122) zu veranlassen, eine Seite des Arbeits-Schaltelements (102) mit der Hilfsspannung (121) zu koppeln;
- erste Messdaten an dem ersten Messeingang (211) und zweite Messdaten an dem zweiten Messeingang (212) zu erfassen; und
- auf Basis der ersten Messdaten und auf Basis der zweiten Messdaten einen Zustand des Arbeits-Schaltelements (102) zu bestimmen.

2. Schaltanordnung (200) gemäß Anspruch 1, wobei die Recheneinheit eingerichtet ist,
- zu bestimmen, dass das Sicherheits-Schaltelement (101) geöffnet ist und/oder dass das Arbeits-Schaltelement (102) nicht mit der Arbeitsspannung gekoppelt ist; und
- in Reaktion darauf das Hilfs-Schaltelement (122) zu veranlassen, eine Seite des Arbeits-Schaltelements (102) mit der Hilfsspannung (121) zu koppeln.

3. Schaltanordnung (200) gemäß einem der vorhergehenden Ansprüche, wobei die Recheneinheit eingerichtet ist,
- zu bestimmen, dass das Arbeits-Schaltelement (102) mit der Arbeitsspannung gekoppelt ist; und
- das Hilfs-Schaltelement (122) zu veranlassen, das Arbeits-Schaltelement (102) von der Hilfsspannung (121) zu entkoppeln, solange das Arbeits-Schaltelement (102) mit der Arbeitsspannung gekoppelt ist.

4. Schaltanordnung (200) gemäß einem der vorhergehenden Ansprüche, wobei
- der erste Messpfad (123) einen ersten Spannungsteiler (203) mit einem ersten Mittelpunkt (205) aufweist;
- der erste Spannungsteiler (203) die erste Seite des Arbeits-Schaltelements (102) mit einem Referenz-Potential koppelt;
- der erste Mittelpunkt (205) mit dem ersten Messeingang (211) gekoppelt ist;
- der zweite Messpfad (124) einen zweiten Spannungsteiler (204) mit einem zweiten Mittelpunkt (206) aufweist;
- der zweite Spannungsteiler (204) die zweite Seite des Arbeits-Schaltelements (102) mit dem Referenz-Potential koppelt; und
- der zweite Mittelpunkt (206) mit dem zweiten Messeingang (212) gekoppelt ist.

5. Schaltanordnung (200) gemäß Anspruch 4, wobei
- der erste Mittelpunkt (205) über einen ersten Tiefpassfilter (213), insbesondere über ein erstes RC-Glied, mit dem ersten Messeingang (211) gekoppelt ist; und
- der zweite Mittelpunkt (206) über einen zweiten Tiefpassfilter (214), insbesondere über ein zweites RC-Glied, mit dem zweiten Messeingang (212) gekoppelt ist.

6. Schaltanordnung (200) gemäß einem der Ansprüche 4 bis 5, wobei
- der erste Spannungsteiler (203) einen ersten Highside-Widerstand und der zweite Spannungsteiler (204) einen zweiten Highside-Widerstand aufweisen;
- der erste Highside-Widerstand mit der ersten Seite des Arbeits-Schaltelements (102) und der zweite Highside-Widerstand mit der zweiten Seite des Arbeits-Schaltelements (102) gekoppelt sind; und
- der erste Highside-Widerstand und der zweite Highside-Widerstand
- für einen Betrieb mit der Arbeitsspannung ausgelegt sind; und/oder
- bei Betrieb mit der Arbeitsspannung einen Strom durch den ersten bzw. zweiten Spannungsteiler (203, 204) derart begrenzen, dass eine Spannung an dem ersten bzw. zweiten Mittelpunkt (205, 206) eine Logikspannung (221) der Recheneinheit nicht überschreitet.

7. Schaltanordnung (200) gemäß einem der Ansprüche 4 bis 6, wobei
- der erste Messpfad (123) eine erste Diode (222) umfasst, über die der erste Mittelpunkt (205) des ersten Spannungsteilers (203) mit einer Logikspannung (221) der Recheneinheit gekoppelt ist; und
- der zweite Messpfad (124) eine zweite Diode (222) umfasst, über die der zweite Mittelpunkt (206) des zweiten Spannungsteilers (204) mit der Logikspannung (221) der Recheneinheit gekoppelt ist.

8. Schaltanordnung (200) gemäß einem der vorhergehenden Ansprüche, wobei das Hilfs-Schaltelement (122) eine Reihenschaltung aus einem Hilfs-Transistor (201), insbesondere einem Metalloxid-Halbleiter, MOS, Transistor, und einer Hilfs-Diode (202) umfasst, die ein Richtung zu der Hilfsspannung (121) sperrend ist.

9. Schaltanordnung (200) gemäß einem der vorhergehenden Ansprüche, wobei
- die Arbeitsspannung eine Wechselspannung ist; und
- die Hilfsspannung (121) eine Gleichspannung ist; und/oder
- die Schaltanordnung (200) einen Wandler umfasst, der eingerichtet ist, die Hilfsspannung (121) aus der Arbeitsspannung zu erzeugen.

10. Schaltanordnung (200) gemäß einem der vorhergehenden Ansprüche, wobei
- das Sicherheits-Schaltelement (101) und/oder das Arbeits-Schaltelement (102) ein Relais umfassen;
- das Arbeits-Schaltelement (102) ausgebildet ist, die Energieversorgung der Last (103) bereitzustellen oder zu unterbinden; und/oder
- das Sicherheits-Schaltelement (101) ausgebildet ist, die Arbeitsspannung an dem Arbeits-Schaltelement (102) bereitzustellen oder von dem Arbeits-Schaltelement (102) zu entkoppeln.
